# EUROPEAN PATENT SPECIFICATION

(11) **EP 4 729 974 B1**
(45) Date of publication and mention of the grant of the patent: **28.10.2026**
(21) Application number: 25153018.4
(22) Date of filing: 21.01.2025
(51) Int. Cl.: G01R 35/00

(54) **HIGH-FREQUENCY COMPONENT TEST DEVICE AND METHOD THEREOF**
HOCHFREQUENZKOMPONENTEN-TESTVORRICHTUNG UND VERFAHREN DAFÜR
DISPOSITIF DE TEST DE COMPOSANT HAUTE FRÉQUENCE ET PROCÉDÉ ASSOCIÉ

(30) Priority: 21.10.2024 US 202418921460
(43) Date of publication of application: 22.04.2026
(73) Proprietor: Industrial Technology Research Institute, 310401 Hsinchu (TW)
(72) Inventor: LI, Sih-Han, 238 New Taipei City (TW); ZHANG, Jie, 234 New Taipei City (TW); MEI, Peng-I, 973 Ji'an Township, Hualien County (TW)
(74) Representative: Krauns, Christian

(56) References cited:
- CN-A- 116 522 832
- US-A1- 2013 032 799
- US-A1- 2013 093 451
- US-A1- 2022 341 978
- QINGHONG BU ET AL: "Evaluation of L-2L De-Embedding Method Considering Misalignment of Contact Position for Millimeter-Wave CMOS Circuit Design", IEICE TRANSACTIONS ON ELECTRONICS, INSTITUTE OF ELECTRONICS, TOKYO, JP, vol. E95C, no. 5, 1 May 2012 (2012-05-01), pages 942 - 948, XP001575740, ISSN: 0916-8524, [retrieved on 20120501], DOI: 10.1587/TRANSELE.E95.C.942
- HSIAO-TSUNG YEN ET AL: "TSV RF de-embedding method and modeling for 3DIC", ADVANCED SEMICONDUCTOR MANUFACTURING CONFERENCE (ASMC), 2012 23RD ANNUAL SEMI, IEEE, 15 May 2012 (2012-05-15), pages 394 - 397, XP032449413, ISBN: 978-1-4673-0350-7, DOI: 10.1109/ASMC.2012.6212934

## Description

### BACKGROUND

### Technical Field

The disclosure relates in general to a test device, and more particularly to a high-frequency component test device and a test method thereof.

### Description of the Related Art

Conventional measurement and calibration of a high-frequency component mainly uses SOLT or TRL. SOLT requires four calibration kits including short, open, thru and load kits. TRL requires three set of test keys including thru, reflect and line keys. The above calibration technologies normally use different calibration methods in response to specific measurement requirements (such as broadband frequency or on-wafer probing), making the calibration steps more complicated.

Additionally, the calibration result of the calibration method using SOLT or TRL may easily be affected by the error generated in each measurement. For example, the calibration result will be affected when the probing depth differs or when the probing position is offset. Therefore, it has become a prominent task for the industries to provide a solution capable of avoiding inaccurate measurement of the device under test (DUT) caused by calibration error.

The US 2022/341978 A1 discloses a high-frequency component test device including a test key and a test module. The test key includes a front-level key and a back-level key which are arranged symmetrically and have the same electrical length and characteristic impedance. The test module is used to measure an S parameter of the front-level key and the back-level key connected directly and an S parameter of a structure where a DUT is added between the front-level key and the back-level key. The test module performs S parameter calculation in the frequency domain and converts the S parameter into an ABCD parameter matrix, and then obtains an ABCD parameter of a de-embedded DUT using a matrix root-opening operation and an inverse matrix operation.

### SUMMARY

The disclosure is directed to a high-frequency component test device and a method thereof capable of reducing calibration error.

The problem of the present invention is solved by a high-frequency component test device according to the independent claim 1 as well as by a high-frequency component test method according to the independent claim 7. The dependent claims refer to further advantageous developments of the present invention.

The above and other aspects of the disclosure will become better understood with regard to the following detailed description of the preferred but non-limiting embodiment(s). The following description is made with reference to the accompanying drawings.

### BRIEF DESCRIPTION OF THE DRAWINGS

FIGS. 1 and 2 respectively are schematic diagrams of a high-frequency component test device according to an embodiment of the present disclosure;
FIG. 3 is a flowchart of a high-frequency component test method according to an embodiment of the present disclosure; and
FIGS. 4A-4D respectively are schematic diagrams illustrating characteristic verification of a high-frequency component test device according to an embodiment of the present disclosure.
FIGS. 5 and 6 respectively illustrate schematic diagrams of a high-frequency component test device according to another embodiment of the present disclosure.
FIGS. 7 and 8 respectively illustrate schematic diagrams of the second test key and the third test key used in the high-frequency component test device.
FIG. 9 illustrates a flow chart of a high-frequency component test method according to an embodiment of the present disclosure.

### DETAILED DESCRIPTION

Technical solutions for the embodiments of the present disclosure are clearly and thoroughly disclosed with accompanying drawings. Obviously, the embodiments disclosed below are only some rather than all of the embodiments of the present disclosure. Besides, the disclosed features, structures or characteristics can be combined in one or more embodiments in any suitable way. In the following disclosure, many detailed descriptions are provided for the embodiments of the present disclosure to be better and fully understood. However, anyone ordinarily skilled in the art of the disclosure will understand that technical solution for the present disclosure can be implemented without one or some of the specific details disclosed below or can be implemented using other methods, devices, or steps. In some circumstances, generally known methods, devices, implementations, or operations of the technical solution capable of implementing the present disclosure are not necessarily illustrated or disclosed in greater details lest the aspects of the present disclosure might be distracted.

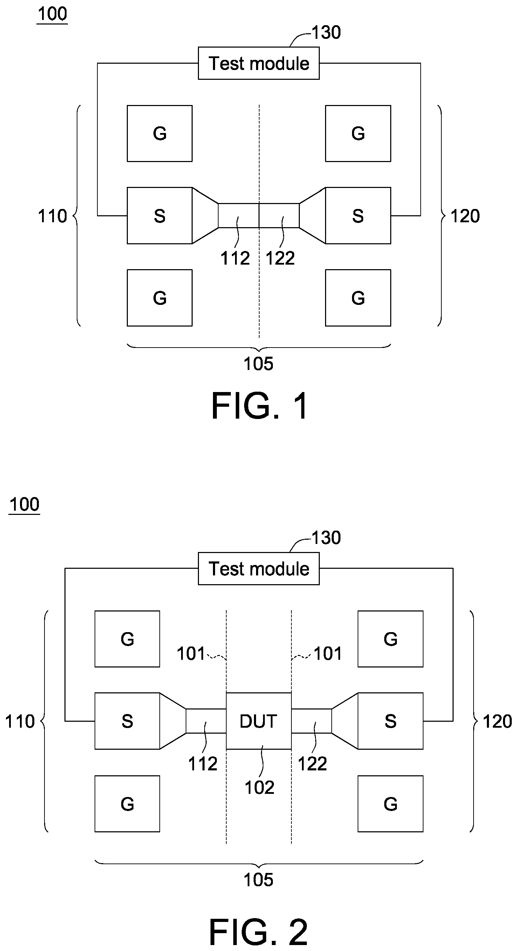

In the present embodiment, high-frequency performance of a device such as a radio frequency emitter or a microwave device is represented by a scattering parameter (S parameter). The current S parameter test device generates a large parasitic effect, so that the S parameter obtained by an under-test high-frequency component cannot correctly represent the performance of the high-frequency component. Thus, a test key is disposed on the test device of the present embodiment to define a de-embedded plane 101 of the high-frequency component, that is, the plane between the intrinsic component (DUT 102) and the parasitic component (test device 100) as indicated in FIG. 2. By removing the parasitic effect generated by the test device in a high-frequency working state, an accurate intrinsic transmission parameter will be obtained.

Referring to FIGS. 1 and 2, schematic diagrams of a high-frequency component test device 100 according to an embodiment of the present disclosure are respectively shown. In FIG. 1, the high-frequency component test device 100 includes a test key 105 and a test module 130. The test key 105 includes a front-level key 110 and a back-level key 120. The front-level key 110 and the back-level key 120 are symmetrically arranged and have the same electrical length and characteristic impedance. In an embodiment, the front-level key 110 and the back-level key 120 exemplarily have a characteristic impedance of 50 Ω, but the present disclosure is not limited thereto. The front-level key 110 and the back-level key 120 can be disposed according to a ground-signal-ground (GSG) configuration. In another embodiment, the front-level key 110 and the back-level key 120 are disposed by a ground-signal (GS) configuration, a ground-signal--ground-signal-ground (GSGSG) configuration or other suitable test configuration. The test module 130 can be a network analyzer.

The front-level key 110 includes a first transmission line 112. The back-level key 120 includes a second transmission line 122. The first transmission line 112 and the second transmission line 122 have the same electrical length and material, such that the transmission parameters on the two sides of the front and the rear are substantially identical. In FIG. 2, the DUT 102 is connected between two transmission lines 112 and 122. A de-embedded plane 101 is respectively formed between the DUT 102 and the first transmission line 112 and between the DUT 102 and the second transmission line 122 (the de-embedded plane 101 is perpendicular to the paper surface), such that the DUT 102 is connected between two de-embedded planes 101. The left-hand structure and the right-hand structure of the de-embedded plane 101 respectively have an intrinsic transmission parameter. The intrinsic transmission parameter of the DUT 102 can be estimated according to the intrinsic transmission parameters of the left-hand structure and the right-hand structure and the transmission parameter of the structure under test. In an embodiment, the intrinsic transmission parameter is represented by an ABCD parameter, for example.

In the present embodiment, the parameter conversion module converts the S parameter into an ABCD parameter, wherein when the front-level key 110 and the back-level key 120 are connected directly, the S parameter can be represented by an ABCD parameter, such as parameter matrix $\left[\begin{matrix}A & B \\ C & D\end{matrix}\right]$. For example, when the front-level key 110 and the back-level key 120 are connected directly, a total voltage V1 and a total current I1 are inputted to one end of the two-port network, and a total voltage V2 and a total current I2 are outputted from the other end of the two-port network, wherein V1=AV2+BI2, I1=CV2+DI2, that is, $\left[\begin{matrix}V 1 \\ I 1\end{matrix}\right] = \left[\begin{matrix}A & B \\ C & D\end{matrix}\right] \left[\begin{matrix}V 2 \\ I 2\end{matrix}\right]$, wherein the relationship among the input voltage V1, the output voltage V2, the input current I1 and the output current I2 is represented by parameters A, B, C and D.

The test module 130 of the present embodiment can obtain the ABCD parameter of the front-level key 110 and the back-level key 120 according to a root-opening operation of the ABCD parameter matrix, and the calculation formula (1) can be expressed as: [Dem]=[PAD][PAD], wherein [PAD] is an ABCD parameter matrix of the front-level key 110 and the back-level key 120; [Dem] is an ABCD parameter matrix when the front-level key 110 and the back-level key 120 are connected directly. In the present embodiment, since the front-level key 110 and the back-level key 120 have the same electrical length and characteristic impedance, the front-level key 110 and the back-level key 120 have the same ABCD parameter matrix. Therefore, the ABCD parameter matrix [PAD] of the front-level key 110 and the back-level key 120 can be obtained by performing a root-opening operation on the ABCD parameter matrix [Dem] of the two directly connected keys 110 and 120 according to formula (1): $\left[PAD\right] = \sqrt{\left[Dem\right]}$.

Also, refer to FIG. 2. When a device under test (DUT) 102 is added between the front-level key 110 and the back-level key 120, the test module 130 measures the S parameter of the structure under test where the DUT 102 is added between the front-level key 110 and the back-level key 120. Then, the test module 130 converts the S parameter into an ABCD parameter, and then obtains the ABCD parameter of a de-embedded DUT 102 according to an inverse matrix. The calculation formula (2) is expressed as: [DUT]=[PAD][Golden][PAD], wherein [Golden] is an ABCD parameter matrix of the de-embedded DUT 102; [DUT] is an ABCD parameter matrix when the front-level key 110 and the back-level key 120 are directly connected to the DUT 102. Based on formula (2), [Golden]=[PAD]⁻¹[DUT][PAD]⁻¹, wherein [PAD]⁻¹ is an inverse matrix of the ABCD parameter matrix of the front-level key 110 and the back-level key 120, that is, ${\left[PAD\right]}^{- 1} = {\left(\sqrt{\left[Dem\right]}\right)}^{- 1}$ .

In the present embodiment, with only one set of de-embedded test keys, the high-frequency component test device 100 can remove the parasitic effect of extra layout and tracing caused by measurement, not only increasing the de-embedded test speed and accuracy but also reducing probing error.

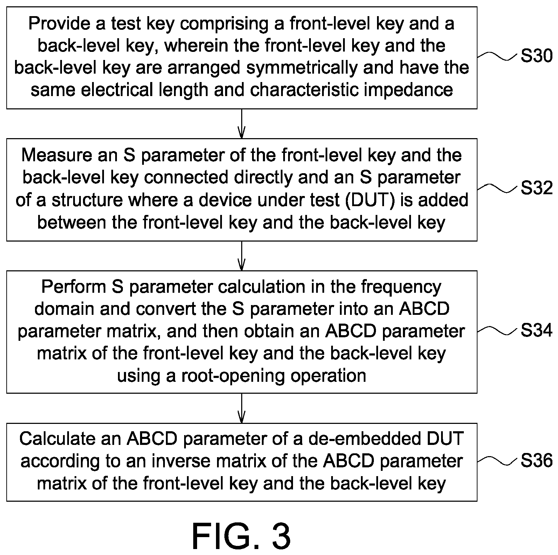

Refer to FIGS. 1-3. FIG. 3 is a flowchart of a high-frequency component test method according to an embodiment of the present disclosure. Firstly, in step S30, a test key 105 comprising a front-level key 110 and a back-level key 120 is provided, the front-level key 110 and the back-level key 120 are arranged symmetrically and have the same electrical length and characteristic impedance. In step S32, an S parameter of the front-level key 110 and the back-level key 120 connected directly and an S parameter of a structure where a device under test (DUT) 102 is added between the front-level key 110 and the back-level key 120 are measured. In step S34, the S parameter calculation is performed in the frequency domain and the S parameter is converted into an ABCD parameter matrix, and then an ABCD parameter matrix of the front-level key 110 and the back-level key 120 is obtained using a root-opening operation. In step S36, an ABCD parameter of a de-embedded DUT 102 is calculated according to an inverse matrix of the ABCD parameter matrix of the front-level key 110 and the back-level key 120.

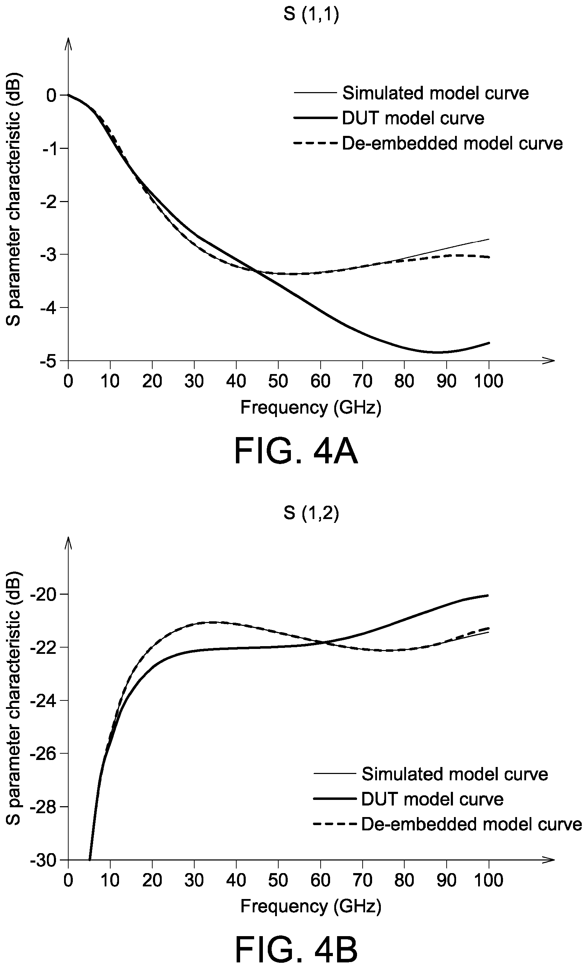

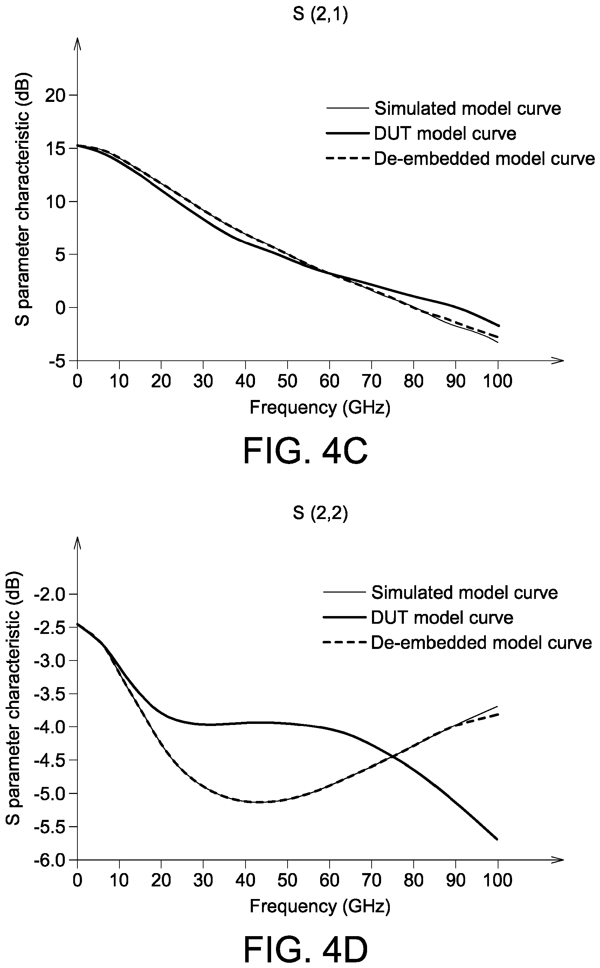

Referring FIGS. 4A-4D, schematic diagrams illustrating characteristic verification of S parameter of a high-frequency component test device 100 according to an embodiment of the present disclosure are respectively shown. In FIG. 4A, S(1,1) parameter is an input reflection coefficient, that is, an input return loss. In FIG. 4B, S(1,2) parameter is a reverse transmission coefficient, that is, isolation. In FIG. 4C, S(2,1) parameter is a forward transmission coefficient, that is, gain. In FIG. 4D, S(2,2) parameter is an output reflection coefficient, that is, an output return loss. In the present embodiment, feasibility and characteristic verification of S parameter are verified using simulation, and a comparison between the simulated model curve, DUT model curve and de-embedded model curve shows that an intrinsic transmission parameter close to the DUT 102 can be obtained using the de-embedded procedure of the present embodiment. Simulation is performed until the error in the curve fitting of 100GHz small signal is less than 10%. In another embodiment, when the verification is performed using the transmission key and the test key, simulation is performed until the error in the characteristic impedance Z0 and transmission line length βL of the 67GHz small signal phase can be less than 8%.

According to the high-frequency component test device and the test method thereof disclosed in above embodiments of the present disclosure, only one test key is used as calibration kit, the front-level key and the back-level key of the test key have the same electrical length and characteristic impedance, the characteristic impedance is 50 Ω being the same as the impedance of the probe, hence avoiding inaccurate measurement of the DUT caused by calibration error. In comparison to the conventional measurement and calibration of a high-frequency component which mainly use SOLT or TRL, the method of the present embodiment can reduce calibration steps and remove the parasitic effect generated by the test device in a high-frequency working state, so as to obtain an accurate S parameter.

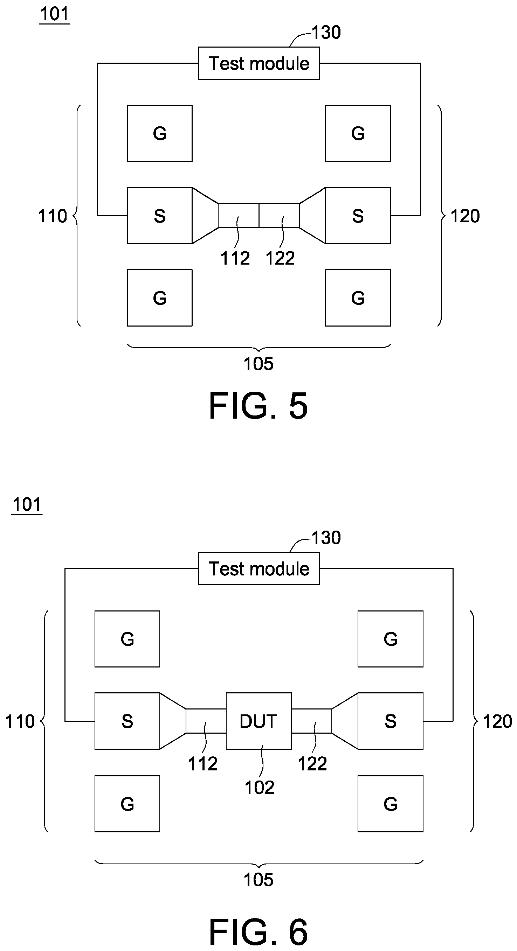

Referring to FIGS. 5 and 6, schematic diagrams of a high-frequency component test device 101 according to another embodiment of the present disclosure are respectively shown. In FIG. 5, the high-frequency component test device 101 includes a first test key 105 and a test module 130. The first test key 105 includes a first front-level key 110 and a first back-level key 120. The first front-level key 110 and the first back-level key 120 are symmetrically arranged and have the same electrical length and characteristic impedance. In an embodiment, the first front-level key 110 and the first back-level key 120 exemplarily have a characteristic impedance of 50 Ω, but the present disclosure is not limited thereto. The first front-level key 110 and the first back-level key 120 can be disposed according to GSG configuration, GSGSG configuration or other suitable test configuration. The test module 130 can be a network analyzer.

The first front-level key 110 may include a first transmission line 112. The first back-level key 120 may include a second transmission line 122. The first transmission line 112 and the second transmission line 122 have the same electrical length and material, such that the transmission parameters on the two sides of the front and the rear are substantially identical. In FIG. 6, the DUT 102 is connected between the first front-level key 110 and the first back-level key 120. The intrinsic transmission parameter of the DUT 102 can be estimated according to the intrinsic transmission parameters of the left-hand structure and the right-hand structure and the transmission parameter of the tested structure. In an embodiment, the intrinsic transmission parameter is represented by an ABCD parameter, for example.

In the present embodiment, the parameter conversion module converts the S parameter into an ABCD parameter, wherein when the first front-level key 110 and the first back-level key 120 are connected directly, the S parameter can be represented by an ABCD parameter, such as parameter matrix $\left[\begin{matrix}A & B \\ C & D\end{matrix}\right]$. For example, when the first front-level key 110 and the first back-level key 120 are connected directly, a total voltage V1 and a total current I1 are inputted to one end of the two-port network, and a total voltage V2 and a total current I2 are outputted from the other end of the two-port network, wherein V1=AV2+BI2, I1=CV2+DI2, that is, $\left[\begin{matrix}V 1 \\ I 1\end{matrix}\right] = \left[\begin{matrix}A & B \\ C & D\end{matrix}\right] \left[\begin{matrix}V 2 \\ I 2\end{matrix}\right]$, wherein the relationship among the input voltage V1, the output voltage V2, the input current I1 and the output current I2 is represented by parameters A, B, C and D.

The test module 130 of the present embodiment can obtain the ABCD parameter of the first front-level key 110 and the first back-level key 120 according to a root-opening operation of the ABCD parameter matrix, and the calculation formula (1') can be expressed as: [Dem1]=[PAD][PAD], wherein [PAD] is an ABCD parameter matrix of the first front-level key 110 and the first back-level key 120; [Dem1] is an ABCD parameter matrix when the first front-level key 110 and the first back-level key 120 are connected directly. In the present embodiment, since the first front-level key 110 and the first back-level key 120 have the same electrical length and characteristic impedance, the first front-level key 110 and the first back-level key 120 have the same ABCD parameter matrix. Therefore, the ABCD parameter matrix [PAD] of the first front-level key 110 and the first back-level key 120 can be obtained by performing a root-opening operation on the ABCD parameter matrix [Dem1] of the two directly connected keys 110 and 120 according to formula (1'), and is expressed as, $\left[PAD\right] = \sqrt{\left[Dem1\right]}$.

Also, refer to FIG. 6. When a device under test (DUT) 102 is added between the first front-level key 110 and the first back-level key 120, the test module 130 measures the S parameter of the structure where the DUT 102 is added between the first front-level key 110 and the first back-level key 120. Then, the test module 130 converts the S parameter into an ABCD parameter, and then obtains the ABCD parameter of a de-embedded DUT 102 according to an inverse matrix. The calculation formula (2) is expressed as: [DUT]=[PAD][Golden][PAD], wherein [Golden] is an ABCD parameter matrix of the de-embedded DUT 102; [DUT] is an ABCD parameter matrix when the first front-level key 110 and the first back-level key 120 are directly connected to the DUT 102. Based on formula (2), [Golden]=[PAD]⁻¹[DUT][PAD]⁻¹ is obtained, wherein [PAD]⁻¹ is an inverse matrix of the ABCD parameter matrix of the first front-level key 110 and the first back-level key 120, that is, ${\left[PAD\right]}^{- 1} = {\left(\sqrt{\left[Dem1\right]}\right)}^{- 1}$.

In one embodiment, the high-frequency component test device 101 uses the first test key 105 in the de-embedded test method to remove the parasitic effect of extra layout and tracing caused by measurement, not only increasing the de-embedded test speed and accuracy but also reducing probing error. In addition, the high-frequency component test device 101 also verifies whether the inverse matrix of the ABCD parameter matrix of the first front-level key 110 and the first back-level key 120 is correct by measuring the ABCD parameter matrix of the second test key 205 and the third test key 305 to correctly calculate the ABCD parameters of the de-embedded DUT 102.

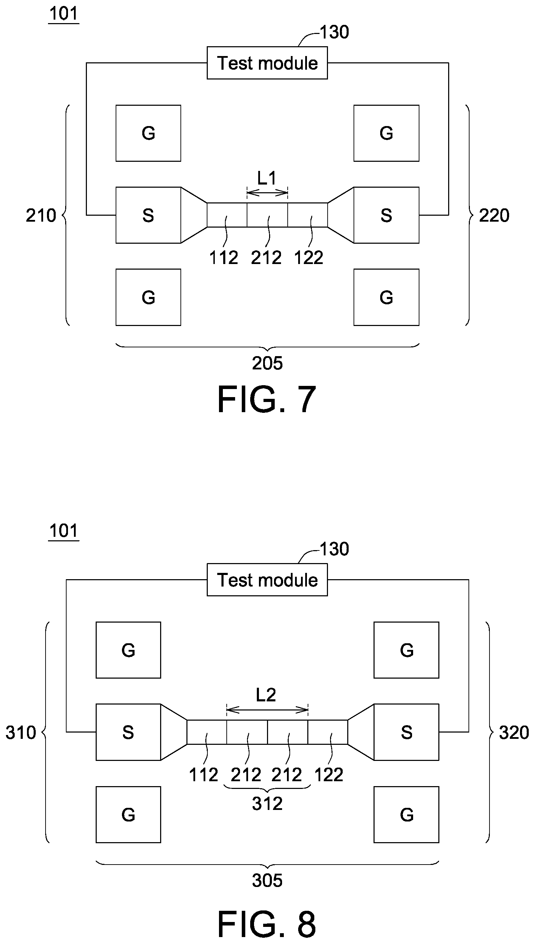

Referring to FIGS. 7 and 8, schematic diagrams of the second test key 205 and the third test key 305 used in the high-frequency component test device 101 are respectively illustrated. The second test key 205 includes a second front-level key 210, a first line segment 212 and a second back-level key 220 connected to each other. The second front-level key 210 and the second back-level key 220 have the same electrical length and characteristic impedance (e.g., 50 ohms). The second front-level key 210 and the second back-level key 220 are arranged, for example, according to GSG, GGSSG or other suitable test configurations. In addition, the third test key 305 includes a third front-level key 310, a second line segment 312 and a third back-level key 320 connected to each other. The third front-level key 310 and the third back-level key 320 have the same electrical length and characteristic impedance (e.g., 50 ohms). The third front-level key 310 and the third back-level key 320 are arranged, for example, according to GSG, GGSSG or other suitable test configurations.

In one embodiment, the first test key 105, the second test key 205 and the third test key 305 are, for example, coplanar waveguides (CPW) or microstrip lines respectively, and the transmission line of each of the first to third test keys has the same characteristic impedance (e.g., 50 ohms). In addition, the length L2 of the second line segment 312 is, for example, twice the length L1 of the first line segment 212, that is, L2=2*L1. In one embodiment, the second line segment 312 may be formed by two first line segments 212 connected to each other or may be composed of a single line segment.

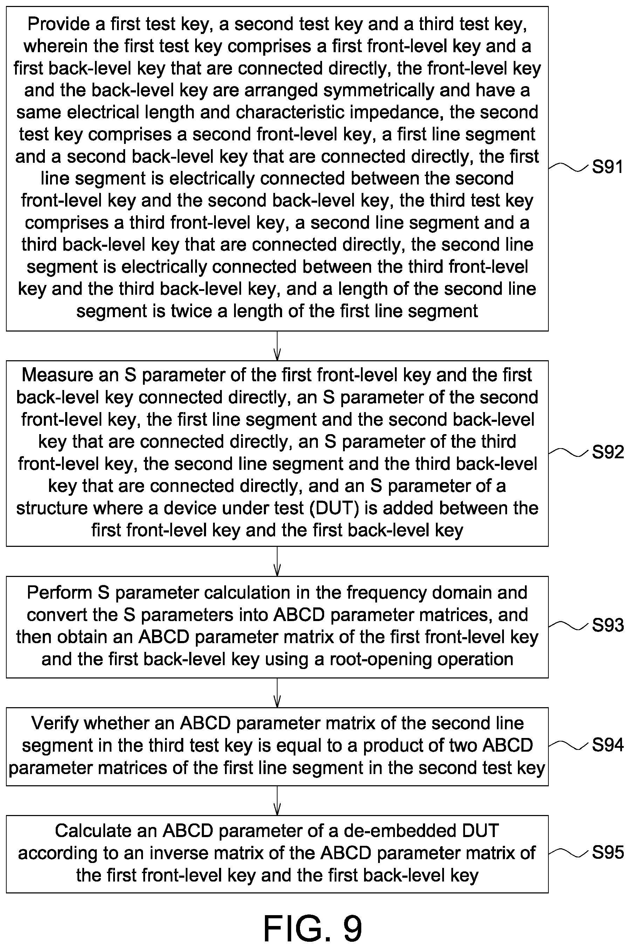

Refer to FIGS. 5 to 9. FIG. 9 illustrates a flow chart of a high-frequency component test method according to an embodiment of the present disclosure. First, in step S91, a first test key 105, a second test key 205 and a third test key 305 are provided. The first test key 105 includes a first front-level key 110 and a first back-level key 120 directly connected, the second test key 205 includes a second front-level key 210, a first line segment 212 and a second back-level key 220 that are directly connected. The first line segment 212 is electrically connected between the second front-level key 210 and the third back-level key 220. The third test key 305 includes a third front-level key 310, a second line segment 312 and a third back-level key 320 that are directly connected. The second line segment 312 is electrically connected between the third front-level key 310 and the third back-level key 320, and the length L2 of the second line segment 312 is twice the length L1 of the first line segment 212. In step S92, the S parameter of the first front-level key 110 and the first back-level key 120 directly connected is measured; the S parameter of the second front-level key 210, the first line segment 212 and the second back-level key 220 directly connected is measured; the S parameter of the third front-level key 310, the second line segment 312 and the third back-level key 320 directly connected is measured; and the S parameter of a structure where the DUT 102 is added between the first front-level key 110 and the first back-level key 120 is measured. In step S93, S parameter calculation is performed in the frequency domain and the S parameter of the first test key 105 is converted into an ABCD parameter matrix, and then the ABCD parameter matrix of the first front-level key 110 and the first back-level key 120 is obtained by using a root-opening operation, as described above, it can be obtained from formula (1'): $\left[PAD\right] = \sqrt{\left[Dem1\right]}$. In step S94, the S parameter of the second test key 205 is converted into an ABCD parameter matrix, the S parameter of the third test key 305 is converted into an ABCD parameter matrix, and whether the ABCD parameter matrix of the second line segment 312 in the third test key 305 is equal to the product of two ABCD parameter matrices of the first line segment 212 in the second test key 205 is verified. In step S95, the ABCD parameter of a de-embedded DUT 102 is calculated according to the inverse matrix of the ABCD parameter matrix of the first front-level key 110 and the first back-level key 120.

In step S94, [PAD] is an ABCD parameter matrix of the second front-level key 210 and the second back-level key 220, [Line1] is an ABCD parameter matrix of the first line segment 212, and [Dem2] is an ABCD parameter matrix of the second front-level key 210, the first line segment 212, and the second back-level key 220 that are directly connected, the calculation formula (3) is expressed as follows: [Dem2]=[PAD][Line1][PAD]. Based on the calculation formula (3), [Line1]=[PAD] ¹[Dem2][PAD]⁻¹ is obtained, where [PAD]⁻¹ is an inverse matrix of the ABCD parameter matrix of the second front-level key 210 and the second back-level key 220.

In addition, in step S94, [PAD] is an ABCD parameter matrix of the third front-level key 310 and the third back-level key 320, [Line2] is an ABCD parameter matrix of the second line segment 312, and [Dem3] is an ABCD parameter matrix of the third front-level key 310, the second line segment 312 and the third back-level key 320 that are directly connected, where the calculation formula (4) is expressed as follows: [Dem3]=[PAD][Line2][PAD]. Based on the calculation formula (4), [Line2]=[PAD]⁻¹[Dem3][PAD]⁻¹ is obtained, where [PAD]⁻¹ is an inverse matrix of the ABCD parameter matrix of the third front-level key 310 and the third back-level key 320.

In step S94, when the test module 130 verifies that the ABCD parameter matrix of the second line segment 312 in the third test key 305 is equal to the product of the two ABCD parameter matrices of the first line segment 212, that is, [Line2]=[Line1][Line1] is satisfied, indicating that the inverse matrix [PAD]⁻¹ of the ABCD parameter matrix of the first front-level key 110 and the first back-level key 120 is correct. On the contrary, when [Line2]=[Line1][Line1] is not satisfied, indicating that the inverse matrix [PAD]⁻¹ of the ABCD parameter matrix of the first front-level key 110 and the first back-level key 120 is incorrect, so that the ABCD parameter matrix of the de-embedding DUT 102 cannot be calculated correctly.

In step S95, [Golden] is the ABCD parameter matrix of the de-embedded DUT 102, and [DUT] is an ABCD parameter matrix of the first front-level key 110, the DUT 102 and the first back-level key 120 that are directly connected. The calculation formula (2) is expressed as follows: [DUT]=[PAD][Golden][PAD]. Based on the calculation formula (2), [Golden]=[PAD]⁻¹ [DUT][PAD]⁻¹ is obtained, where [PAD]⁻¹ is an inverse matrix of the ABCD parameter matrix of the first front-level key 110 and the first back-level key 120, that is, ${\left[PAD\right]}^{- 1} = {\left(\sqrt{\left[Dem1\right]}\right)}^{- 1}$. When the inverse matrix [PAD]⁻¹ of the ABCD parameter matrix of the first front-level key 110 and the first back-level key 120 is verified to be correct, the ABCD parameter matrix of the de-embedded DUT 102 can be correctly calculated.

The high-frequency component test device 101 of the present disclosure can avoid measurement inaccuracies of the DUT due to calibration errors through the above verification method. For example, under W-band operation (such as in the range of 75-110 GHz), the calibration errors caused by different probing depths or probing position deviations can be prevented to have better measurement results for the DUT

While the disclosure has been described by way of example and in terms of the preferred embodiment(s), it is to be understood that the disclosure is not limited thereto. On the contrary, it is intended to cover various modifications and similar arrangements and procedures, without departing from the scope of the invention, as defined in the appended claims.

## Claims

1. A high-frequency component test device (100, 101), comprising:
a first test key (110, 120), comprising a first front-level key (110) and a first back-level key (120), wherein the front-level key (110) and the back-level key (120) are arranged symmetrically and have a same electrical length and characteristic impedance;
a second test key (210, 212, 220), including a second front-level key (210), a first line segment (212) and a second back-level key (220) that are directly connected, and the first line segment (212) being electrically connected between the second front-level key (210) and the second back-level key (220);
a third test key (310, 312, 320), including a third front-level key (310), a second line segment (312) and a third back-level key (320) that are directly connected, the second line segment (312) being electrically connected between the third front-level key (310) and the third back-level key (320), and a length of the second line segment (312) being twice a length of the first line segment (212); and
a test module (130) configured to measure an S parameter of the first front-level key (110) and the first back-level key (120) connected directly and an S parameter of a tested structure where a device under test (DUT) (102) is added between the first front-level key (110) and the first back-level key (120) and an S parameter of the second front-level key (210), the first line segment (212) and the second back-level key (220) that are connected directly, an S parameter of the third front-level key (310), the second line segment (312) and the third back-level key (320) that are connected directly, wherein the test module (130) is configured to perform S parameter calculation in the frequency domain and convert the S parameters into ABCD parameter matrices, and obtain an ABCD parameter matrix of the first front-level key (110) and the first back-level key (120) using a root-opening operation,
wherein the test module is further configured to verify the condition whereby the ABCD parameter matrix of the second line segment (312) is equal to the product of the two ABCD parameter matrices of the first line segment (212), indicating that the inverse matrix of the ABCD parameter matrix of the first front-level key (110) and the first back-level key (120) used for calculating the ABCD parameter of a de-embedded DUT (102) is correct; or on the contrary if said condition is not satisfied, indicating that said inverse matrix is incorrect, so that the ABCD parameter matrix of the de-embedding DUT (102) cannot be calculated correctly.

2. The high-frequency component test device (100, 101) according to claim 1, wherein [PAD] is an ABCD parameter matrix of the first front-level key (110) and the first back-level key (120), [Dem1] is an ABCD parameter matrix when the first front-level key (110) and the first back-level key (120) are connected directly, [Dem1]=[PAD][PAD], wherein the ABCD parameter matrix of the first front-level key (110) and the first back-level key (120) is expressed as: $\left[PAD\right] = \sqrt{\left[Dem1\right]}$.

3. The high-frequency component test device (100, 101) according to claim 1 or 2, wherein [PAD] is an ABCD parameter matrix of the second front-level key (210) and the second back-level key (220), [Line1] is an ABCD parameter matrix of the first line segment (212), [Dem2] is an ABCD parameter matrix when the second front-level key (210), the first line segment (212) and the second back-level key (220) are directly connected, wherein [Dem2]=[PAD][Line1][PAD].

4. The high-frequency component test device (100, 101) according to anyone of the claims 1 to 3, wherein [PAD] is an ABCD parameter matrix of the third front-level key (310) and the third back-level key (320), [Line2] is an ABCD parameter matrix of the second line segment (312), and [Dem3] is an ABCD parameter matrix when the third front-level key (310), the second line segment (312) and the third back-level key (320) are directly connected, wherein [Dem3]=[PAD][Line2][PAD].

5. The high-frequency component test device (100, 101) according to anyone of the claims 1 to 4, wherein the test module (130) verifies that the ABCD parameter matrix of the second line segment (312) in the third test key is equal to a product of two ABCD parameter matrices of the first line segment (212), and is expressed as [Line2]=[Line1][Line1].

6. The high-frequency component test device (100, 101) according to anyone of the claims 1 to 5, wherein [Golden] is an ABCD parameter matrix of the de-embedded DUT (102), [DUT] is an ABCD parameter matrix when the first front-level key (110), the DUT (102), and the first back-level key (120) are connected directly, [DUT]=[PAD][Golden][PAD], the ABCD parameter matrix of the de-embedded DUT (102) is calculated according to an inverse matrix of the ABCD parameter matrix of the first front-level key (110) and the first back-level key (120) and is expressed as: [Golden]=[PAD]⁻¹[DUT][PAD]⁻¹.

7. A high-frequency component test method, comprising:
providing a first test key (110, 120), a second test key (210, 212, 220) and a third test key (310, 312, 320), the first test key (110, 120) comprising a first front-level key (110) and a first back-level key (120) that are connected directly, wherein the front-level key (110) and the first back-level key (120) are arranged symmetrically and have a same electrical length and characteristic impedance, the second test key (210, 212, 220) comprising a second front-level key (210), a first line segment (212) and a second back-level key (220) that are connected directly, the first line segment (212) being electrically connected between the second front-level key (210) and the second back-level key (220), the third test key (310, 312, 320) comprising a third front-level key (310), a second line segment (312) and a third back-level key (320) that are connected directly, the second line segment (312) being electrically connected between the third front-level key (310) and the third back-level key (320), wherein a length of the second line segment (312) is twice a length of the first line segment (212);
measuring an S parameter of the first front-level key (110) and the first back-level key (120) connected directly, an S parameter of the second front-level key (210), the first line segment (212) and the second back-level key (220) that are connected directly, an S parameter of the third front-level key (310), the second line segment (312) and the third back-level key (320) that are connected directly, and an S parameter of a structure where a device under test (DUT) (102) is added between the first front-level key (110) and the first back-level key (120);
performing S parameter calculation in the frequency domain and converting the S parameters into ABCD parameter matrices, and then obtaining an ABCD parameter matrix of the first front-level key (110) and the first back-level key (120) using a root-opening operation;
verifying whether an ABCD parameter matrix of the second line segment (312) in the third test key is equal to a product of two ABCD parameter matrices of the first line segment (212) in the second test key; and
when it is determined that the ABCD parameter matrix of the second line segment (312) is equal to the product of two ABCD parameter matrices of the first line segment (212), calculating an ABCD parameter of a de-embedded DUT (102) according to an inverse matrix of the ABCD parameter matrix of the first front-level key (110) and the first back-level key (120);
when it is determined that the ABCD parameter matrix of the second line segment (312) is not equal to the product of two ABCD parameter matrices of the first line segment (212), indicating that the inverse matrix of the ABCD parameter matrix of the first front-level key (110) and the first back-level key (120) is incorrect, so that the ABCD parameter matrix of the de-embedding DUT (102) cannot be calculated correctly.

8. The high-frequency component test method according to claim 7, wherein the first test key (110, 120), the second test key (210, 212, 220) and the third test key (310, 312, 320) have the same characteristic impedance.

9. The high-frequency component test method according to claim 7 or 8, wherein [PAD] is an ABCD parameter matrix of the first front-level key (110) and the first back-level key (120), [Dem1] is an ABCD parameter matrix when the first front-level key (110) and the first back-level key (120) are connected directly, [Dem1]=[PAD][PAD], wherein the ABCD parameter matrix of the first front-level key (110) and the first back-level key (120) is expressed as: $\left[PAD\right] = \sqrt{\left[Dem1\right]}$.

10. The high-frequency component test method according to anyone of the claims 7 to 9, wherein [PAD] is an ABCD parameter matrix of the second front-level key (210) and the second back-level key (220), [Line1] is an ABCD parameter matrix of the first line segment (212), [Dem2] is an ABCD parameter matrix when the second front-level key (210), the first line segment (212) and the second back-level key (220) are directly connected, wherein [Dem2]=[PAD][Line1][PAD].

11. The high-frequency component test method according to anyone of the claims 7 to 10, wherein [PAD] is an ABCD parameter matrix of the third front-level key (310) and the third back-level key (320), [Line2] is an ABCD parameter matrix of the second line segment (312), and [Dem3] is an ABCD parameter matrix when the third front-level key (310), the second line segment (312) and the third back-level key (320) are directly connected, wherein [Dem3]=[PAD][Line2][PAD].

12. The high-frequency component test method according to anyone of the claims 9 to 11, wherein it is verified that the ABCD parameter matrix of the second line segment (312) in the third test key is equal to a product of two ABCD parameter matrices of the first line segment (212), and is expressed as [Line2]=[Line1][Line1].

13. The high-frequency component test method according to anyone of the claims 9 to 12, wherein [Golden] is an ABCD parameter matrix of the de-embedded DUT (102), [DUT] is an ABCD parameter matrix when the first front-level key (110), the DUT (102) and the first back-level key (120) are directly connected, [DUT]=[PAD][Golden][PAD], the ABCD parameter matrix of the de-embedded DUT (102) is calculated according to an inverse matrix of the ABCD parameter matrix of the first front-level key (110) and the first back-level key (120) and is expressed as [Golden]=[PAD]⁻¹[DUT][PAD]⁻¹.

## Patentansprüche

1. Hochfrequenzkomponenten-Prüfvorrichtung (100, 101), welche aufweist:
einen ersten Prüfschlüssel (110, 120), der einen ersten Front-Level-Schlüssel (110) und einen ersten Back-Level-Schlüssel (120) aufweist, wobei der Front-Level-Schlüssel (110) und der Back-Level-Schlüssel (120) symmetrisch angeordnet sind und dieselbe elektrische Länge sowie dieselbe charakteristische Impedanz aufweisen,
einen zweiten Prüfschlüssel (210, 212, 220), der einen zweiten Front-Level-Schlüssel (210), ein erstes Liniensegment (212) und einen zweiten Back-Level-Schlüssel (220) aufweist, die direkt miteinander verbunden sind, wobei das erste Liniensegment (212) elektrisch zwischen dem zweiten Front-Level-Schlüssel (210) und dem zweiten Back-Level-Schlüssel (220) geschaltet ist,
einen dritten Prüfschlüssel (310, 312, 320), der einen dritten Front-Level-Schlüssel (310), ein zweites Liniensegment (312) und einen dritten Back-Level-Schlüssel (320) aufweist, die direkt miteinander verbunden sind, wobei das zweite Liniensegment (312) elektrisch zwischen dem dritten Front-Level-Schlüssel (310) und dem dritten Back-Level-Schlüssel (320) geschaltet ist und die Länge des zweiten Liniensegments (312) doppelt so groß wie die Länge des ersten Liniensegments (212) ist, und
ein Prüfmodul (130), das so ausgestaltet ist, dass es einen S-Parameter des ersten Front-Level-Schlüssels (110) und des ersten Back-Level-Schlüssels (120), die direkt miteinander verbunden sind, sowie einen S-Parameter einer geprüften Struktur, bei der eine zu prüfende Vorrichtung, DUT, (102) zwischen dem ersten Front-Level-Schlüssel (110) und dem ersten Back-Level-Schlüssel (120) eingefügt ist, sowie einen S-Parameter des zweiten Front-Level-Schlüssels (210), des ersten Liniensegments (212) und des zweiten Back-Level-Schlüssels (220), die direkt miteinander verbunden sind, einen S-Parameter des dritten Front-Level-Schlüssels (310), des zweiten Liniensegments (312) und des dritten Back-Level-Schlüssels (320) misst, die direkt miteinander verbunden sind, wobei das Prüfmodul (130) ausgestaltet ist, um eine S-Parameter-Berechnung in dem Frequenzbereich durchzuführen und die S-Parameter in ABCD-Parameter-Matrizen umzuwandeln sowie eine ABCD-Parameter-Matrix des ersten Front-Level-Schlüssels (110) und des ersten Back-Level-Schlüssel (120) mittels einer Wurzelauswertungsoperation zu ermitteln,
wobei das Prüfmodul ferner ausgestaltet ist, um die Bedingung zu überprüfen, wonach die ABCD-Parametermatrix des zweiten Liniensegments (312) gleich dem Produkt der beiden ABCD-Parametermatrizen des ersten Liniensegments (212) ist, was anzeigt, dass die Inversmatrix der ABCD-Parametermatrix des ersten Front-Level-Schlüssels (110) und des ersten Back-Level-Schlüssels (120), die zur Berechnung des ABCD-Parameters eines mathematischen Entfernens von Störeffekten bei der DUT (102) verwendet wird, korrekt ist, oder im Gegenteil, wenn die genannte Bedingung nicht erfüllt ist, was anzeigt, dass die genannte Inversmatrix falsch ist, sodass die ABCD-Parametermatrix des mathematischen Entfernens von Störeffekten bei der DUT (102) nicht korrekt berechnet werden kann.

2. Hochfrequenzkomponenten-Prüfvorrichtung (100, 101) nach Anspruch 1, wobei [PAD] eine ABCD-Parametermatrix des ersten Front-Level-Schlüssels (110) und des ersten Back-Level-Schlüssels (120) ist, [Dem1] eine ABCD-Parametermatrix ist, wenn der erste Front-Level-Schlüssel (110) und der erste Back-Level-Schlüssel (120) direkt miteinander verbunden sind, und [Dem1] = [PAD][PAD] ist, wobei die ABCD-Parameter-matrix des ersten Front-Level-Schlüssels (110) und des ersten Back-Level-Schlüssels (120) als $\left[PAD\right] = \sqrt{\left[Dem1\right]}$ ausgedrückt wird.

3. Hochfrequenzkomponenten-Prüfvorrichtung (100, 101) nach Anspruch 1 oder 2, wobei [PAD] eine ABCD-Parametermatrix des Front-Level-Schlüssels (210) und des zweiten Back-Level-Schlüssel (220) ist, [Line1] eine ABCD-Parametermatrix des ersten Liniensegments (212) ist und [Dem2] eine ABCD-Parametermatrix ist, wenn der zweite Front-Level-Schlüssels (210), das erste Liniensegment (212) und der zweite Back-Level-Schlüssel (220) direkt miteinander verbunden sind, wobei [Dem2] = [PAD][Line1][PAD] gilt.

4. Hochfrequenzkomponenten-Prüfvorrichtung (100, 101) nach einem der Ansprüche 1 bis 3, wobei [PAD] eine ABCD-Parametermatrix des dritten Front-Level-Schlüssels (310) und des dritten Back-Level-Schlüssels (320) ist, [Line2] eine ABCD-Parameter-matrix des zweiten Liniensegments (312) ist und [Dem3] eine ABCD-Parametermatrix ist, wenn der dritte Front-Level-Schlüssel (310), das zweite Liniensegment (312) und der dritte Back-Level-Schlüssel (320) direkt miteinander verbunden sind, wobei [Dem3] = [PAD][Line2][PAD] gilt.

5. Hochfrequenzkomponenten-Prüfvorrichtung (100, 101) nach einem der Ansprüche 1 bis 4, wobei das Prüfmodul (130) überprüft, ob die ABCD-Parametermatrix des zweiten Liniensegments (312) in dem dritten Prüfschlüssel gleich dem Produkt zweier ABCD-Parametermatrizen des ersten Liniensegments (212) ist und als [Line2] = [Line1][Line1] ausgedrückt wird.

6. Hochfrequenzkomponenten-Prüfvorrichtung (100, 101) nach einem der Ansprüche 1 bis 5, wobei [Golden] eine ABCD-Parametermatrix des mathematischen Entfernen von Störeffekten bei dem Prüfobjekt, DUT, (102) ist, [DUT] eine ABCD-Parameter-matrix ist, wenn der erste Front-Level-Schlüssel (110), das DUT (102) und der erste Back-Level-Schlüssel (120) direkt miteinander verbunden sind, [DUT] = [PAD][Golden][PAD] ist und die ABCD-Parametermatrix des mathematischen Entfernen von Störeffekten bei dem Prüfobjekt, DUT, (102) gemäß einer Inversmatrix der ABCD-Parametermatrix des ersten Front-Level-Schlüssels (110) und des ersten Back-Level-Schlüssels (120) berechnet wird und als [Golden] = [PAD]⁻¹[DUT][PAD]⁻¹ ausgedrückt wird.

7. Verfahren zum Prüfen von Hochfrequenzkomponenten, welches umfasst:
ein Bereitstellen eines ersten Prüfschlüssels (110, 120), eines zweiten Prüfschlüssels (210, 212, 220) und eines dritten Prüfschlüssels (310, 312, 320), wobei der erste Prüfschlüssel (110, 120) einen ersten Front-Level-Schlüssel (110) und einen ersten Back-Level-Schlüssel (120) aufweist, die direkt miteinander verbunden sind, wobei der Front-Level-Schlüssel (110) und die erste Back-Level-Schlüssel (120) symmetrisch angeordnet sind und dieselbe elektrische Länge sowie dieselbe charakteristische Impedanz aufweisen, wobei der zweite Prüfschlüssel (210, 212, 220) einen zweiten Front-Level-Schlüssel (210), ein erstes Liniensegment (212) und einen zweiten Back-Level-Schlüssel (220) aufweist, die direkt miteinander verbunden sind, wobei das erste Liniensegment (212) elektrisch zwischen dem zweiten Front-Level-Schlüssel (210) und dem zweiten Back-Level-Schlüssel (220) geschaltet ist, wobei der dritte Prüfschlüssel (310, 312, 320) einen dritten Front-Level-Schlüssel (310), ein zweites Liniensegment (312) und einen dritten Back-Level-Schlüssel (320), die direkt miteinander verbunden sind, wobei das zweite Liniensegment (312) elektrisch zwischen der dritten Front-Level-Schlüssel (310) und der dritten Back-Level-Schlüssel (320) geschaltet ist, wobei die Länge des zweiten Liniensegments (312) doppelt so groß wie die Länge des ersten Liniensegments (212) ist,
ein Messen eines S-Parameters des ersten Front-Level-Schlüssels (110) und des ersten Back-Level-Schlüssels (120), die direkt miteinander verbunden sind, eines S-Parameters des zweiten Front-Level-Schlüssels (210), des ersten Liniensegments (212) und des zweiten Back-Level-Schlüssels (220), die direkt miteinander verbunden sind, eines S-Parameters des dritten Front-Level-Schlüssels (310), des zweiten Liniensegments (312) und des dritten Back-Level-Schlüssels (320), die direkt miteinander verbunden sind, sowie eines S-Parameters einer Struktur, bei der eine zu prüfende Vorrichtung, DUT, (102) zwischen dem ersten Front-Level-Schlüssel (110) und dem ersten Back-Level-Schlüssel (120) eingefügt ist,
ein Durchführen einer S-Parameter-Berechnung in dem Frequenzbereich und ein Umwandeln der S-Parameter in ABCD-Parameter-Matrizen sowie ein anschließendes Ermitteln einer ABCD-Parameter-Matrix des ersten Front-Level-Schlüssels (110) und des ersten Back-Level-Schlüssels (120) mittels einer Wurzelauswertungsoperation,
ein Überprüfen, ob eine ABCD-Parametermatrix des zweiten Liniensegments (312) in dem dritten Prüfschlüssel gleich dem Produkt zweier ABCD-Parameter-matrizen des ersten Liniensegments (212) in dem zweiten Prüfschlüssel ist, und
wenn festgestellt wird, dass die ABCD-Parametermatrix des zweiten Liniensegments (312) dem Produkt zweier ABCD-Parametermatrizen des ersten Liniensegments (212) entspricht, ein Berechnen eines ABCD-Parameters eines mathematischen Entfernens von Störeffekten bei der zu prüfenden Vorrichtung, DUT, (102) gemäß einer Inversmatrix der ABCD-Parametermatrix des ersten Front-Level-Schlüssels (110) und des ersten Back-Level-Schlüssels (120),
wenn festgestellt wird, dass die ABCD-Parametermatrix des zweiten Liniensegments (312) nicht gleich dem Produkt zweier ABCD-Parametermatrizen des ersten Liniensegments (212) ist, was anzeigt, dass die Inversmatrix der ABCD-Parameter-matrix des ersten Front-Level-Schlüssels (110) und des ersten Back-Level-Schlüssels (120) falsch ist, sodass die ABCD-Parametermatrix des mathematischen Entfernens von Störeffekten bei der DUT (102) nicht korrekt berechnet werden kann.

8. Verfahren zum Prüfen von Hochfrequenzkomponenten nach Anspruch 7, wobei der erste Prüfschlüssel (110, 120), der zweite Prüfschlüssel (210, 212, 220) und der dritte Prüfschlüssel (310, 312, 320) die gleiche charakteristische Impedanz aufweisen.

9. Verfahren zum Prüfen von Hochfrequenzkomponenten nach Anspruch 7 oder 8, wobei [PAD] eine ABCD-Parametermatrix des ersten Front-Level-Schlüssels (110) und des ersten Back-Level-Schlüssels (120) ist, [Dem1] eine ABCD-Parametermatrix ist, wenn der erste Front-Level-Schlüssel (110) und der erste Back-Level-Schlüssel (120) direkt verbunden sind, und [Dem1] = [PAD][PAD] ist, wobei die ABCD-Parametermatrix des ersten Front-Level-Schlüssels (110) und des ersten Back-Level-Schlüssels (120) als $\left[PAD\right] = \sqrt{\left[Dem1\right]}$ ausgedrückt wird.

10. Verfahren zum Prüfen von Hochfrequenzkomponenten nach einem der Ansprüche 7 bis 9, wobei [PAD] eine ABCD-Parametermatrix des zweiten Front-Level-Schlüssels (210) und des zweiten Back-Level-Schlüssels (220) ist, [Line1] eine ABCD-Parameter-matrix des ersten Liniensegments (212) ist, und [Dem2] eine ABCD-Parametermatrix ist, wenn der zweite Front-Level-Schlüssel (210), das erste Liniensegment (212) und der zweite Back-Level-Schlüssel (220) direkt miteinander verbunden sind, wobei [Dem2] = [PAD][Line1][PAD] gilt.

11. Verfahren zum Prüfen von Hochfrequenzkomponenten nach einem der Ansprüche 7 bis 10, wobei [PAD] eine ABCD-Parametermatrix des dritten Front-Level-Schlüssels (310) und des dritten Back-Level-Schlüssels (320) ist, [Line2] eine ABCD-Parameter-matrix des zweiten Liniensegments (312) ist und [Dem3] eine ABCD-Parametermatrix ist, wenn der dritte Front-Level-Schlüssel (310), das zweite Liniensegment (312) und der dritte Back-Level-Schlüssel (320) direkt miteinander verbunden sind, wobei [Dem3] = [PAD][Line2][PAD] gilt.

12. Verfahren zum Prüfen von Hochfrequenzkomponenten nach einem der Ansprüche 9 bis 11, wobei überprüft wird, ob die ABCD-Parametermatrix des zweiten Liniensegments (312) in dem dritten Prüfschlüssel gleich dem Produkt zweier ABCD-Parameter-matrizen des ersten Liniensegments (212) ist und als [Line2] = [Line1][Line1] ausgedrückt wird.

13. Verfahren zum Prüfen von Hochfrequenzkomponenten nach einem der Ansprüche 9 bis 12, wobei [Golden] eine ABCD-Parametermatrix des mathematischen Entfernen von Störeffekten bei dem Prüfobjekt, DUT, (102) ist, [DUT] eine ABCD-Parameter-matrix ist, wenn der erste Front-Level-Schlüssel (110), das DUT (102) und der erste Back-Level-Schlüssel (120) direkt miteinander verbunden sind, [DUT] = [PAD][Golden][PAD] ist, und die ABCD-Parametermatrix des mathematischen Entfernen von Störeffekten bei dem DUT (102) gemäß einer Inversmatrix der ABCD-Parametermatrix des ersten Front-Level-Schlüssels (110) und des ersten Back-Level-Schlüssels (120) berechnet wird und als [Golden] = [PAD]⁻¹[DUT][PAD]⁻¹ ausgedrückt wird.

## Revendications

1. Dispositif de test de composant haute fréquence (100, 101), comprenant :
un premier motif de test (110, 120), comprenant un premier motif de niveau avant (110) et un premier motif de niveau arrière (120), dans lequel le motif de niveau avant (110) et le motif de niveau arrière (120) sont agencés symétriquement et présentent une longueur électrique et une impédance caractéristique identiques ;
un deuxième motif de test (210, 212, 220), incluant un deuxième motif de niveau avant (210), un premier segment de ligne (212) et un deuxième motif de niveau arrière (220) qui sont directement reliés, le premier segment de ligne (212) étant relié électriquement entre le deuxième motif de niveau avant (210) et le deuxième motif de niveau arrière (220) ;
un troisième motif de test (310, 312, 320), incluant un troisième motif de niveau avant (310), un second segment de ligne (312) et un troisième motif de niveau arrière (320) qui sont directement reliés, le second segment de ligne (312) étant relié électriquement entre le troisième motif de niveau avant (310) et le troisième motif de niveau arrière (320), et une longueur du second segment de ligne (312) étant le double de la longueur du premier segment de ligne (212) ; et
un module de test (130) configuré pour mesurer un paramètre S du premier motif de niveau avant (110) et du premier motif de niveau arrière (120) reliés directement, un paramètre S d'une structure sous test dans laquelle un dispositif à l'essai (DUT) (102) est ajouté entre le premier motif de niveau avant (110) et le premier motif de niveau arrière (120), un paramètre S du deuxième motif de niveau avant (210), du premier segment de ligne (212) et du deuxième motif de niveau arrière (220) qui sont reliés directement, et un paramètre S du troisième motif de niveau avant (310), du second segment de ligne (312) et du troisième motif de niveau arrière (320) qui sont reliés directement, dans lequel le module de test (130) est configuré pour effectuer un calcul de paramètres S dans le domaine fréquentiel, convertir les paramètres S en matrices de paramètres ABCD, et obtenir une matrice de paramètres ABCD du premier motif de niveau avant (110) et du premier motif de niveau arrière (120) au moyen d'une opération d'extraction de racine,
dans lequel le module de test est en outre configuré pour vérifier la condition selon laquelle la matrice de paramètres ABCD du second segment de ligne (312) est égale au produit des deux matrices de paramètres ABCD du premier segment de ligne (212), pour indiquer que la matrice inverse de la matrice de paramètres ABCD du premier motif de niveau avant (110) et du premier motif de niveau arrière (120) utilisée pour calculer le paramètre ABCD d'un DUT désencastré (102) est correcte ; ou au contraire, si ladite condition n'est pas satisfaite, pour indiquer que ladite matrice inverse est incorrecte, de sorte que la matrice de paramètres ABCD du processus de désencastrement du DUT (102) ne peut pas être calculée correctement.

2. Dispositif de test de composant haute fréquence (100, 101) selon la revendication 1, dans lequel [PAD] est une matrice de paramètres ABCD du premier motif de niveau avant (110) et du premier motif de niveau arrière (120), [Dem1] est une matrice de paramètres ABCD lorsque le premier motif de niveau avant (110) et le premier motif de niveau arrière (120) sont reliés directement, [Dem1]=[PAD][PAD], dans lequel la matrice de paramètres ABCD du premier motif de niveau avant (110) et du premier motif de niveau arrière (120) est exprimée comme suit : $\left[PAD\right] = \sqrt{\left[Dem1\right]}$.

3. Dispositif de test de composant haute fréquence (100, 101) selon la revendication 1 ou 2, dans lequel [PAD] est une matrice de paramètres ABCD du deuxième motif de niveau avant (210) et du deuxième motif de niveau arrière (220), [Line1] est une matrice de paramètres ABCD du premier segment de ligne (212), [Dem2] est une matrice de paramètres ABCD lorsque le deuxième motif de niveau avant (210), le premier segment de ligne (212) et le deuxième motif de niveau arrière (220) sont directement reliés, dans lequel [Dem2]=[PAD][Line1][PAD].

4. Dispositif de test de composant haute fréquence (100, 101) selon l'une quelconque des revendications 1 à 3, dans lequel [PAD] est une matrice de paramètres ABCD du troisième motif de niveau avant (310) et du troisième motif de niveau arrière (320), [Line2] est une matrice de paramètres ABCD du second segment de ligne (312), et [Dem3] est une matrice de paramètres ABCD lorsque le troisième motif de niveau avant (310), le second segment de ligne (312) et le troisième motif de niveau arrière (320) sont directement reliés, dans lequel [Dem3]=[PAD][Line2][PAD].

5. Dispositif de test de composant haute fréquence (100, 101) selon l'une quelconque des revendications 1 à 4, dans lequel le module de test (130) vérifie que la matrice de paramètres ABCD du second segment de ligne (312) dans le troisième motif de test est égale à un produit de deux matrices de paramètres ABCD du premier segment de ligne (212), et est exprimée par [Line2]=[Line1][Line1].

6. Dispositif de test de composant haute fréquence (100, 101) selon l'une quelconque des revendications 1 à 5, dans lequel [Golden] est une matrice de paramètres ABCD du DUT désencastré (102), [DUT] est une matrice de paramètres ABCD lorsque le premier motif de niveau avant (110), le DUT (102) et le premier motif de niveau arrière (120) sont reliés directement, [DUT]=[PAD][Golden][PAD], la matrice de paramètres ABCD du DUT désencastré (102) est calculée selon une matrice inverse de la matrice de paramètres ABCD du premier motif de niveau avant (110) et du premier motif de niveau arrière (120) et est exprimée comme suit : [Golden]=[PAD]⁻¹[DUT][PAD]⁻¹.

7. Procédé de test de composant haute fréquence, comprenant :
la fourniture d'un premier motif de test (110, 120), d'un deuxième motif de test (210, 212, 220) et d'un troisième motif de test (310, 312, 320), le premier motif de test (110, 120) comprenant un premier motif de niveau avant (110) et un premier motif de niveau arrière (120) qui sont reliés directement, dans lequel le motif de niveau avant (110) et le premier motif de niveau arrière (120) sont agencés symétriquement et présentent une longueur électrique et une impédance caractéristique identiques, le deuxième motif de test (210, 212, 220) comprenant un deuxième motif de niveau avant (210), un premier segment de ligne (212) et un deuxième motif de niveau arrière (220) qui sont reliés directement, le premier segment de ligne (212) étant relié électriquement entre le deuxième motif de niveau avant (210) et le deuxième motif de niveau arrière (220), le troisième motif de test (310, 312, 320) comprenant un troisième motif de niveau avant (310), un second segment de ligne (312) et un troisième motif de niveau arrière (320) qui sont reliés directement, le second segment de ligne (312) étant relié électriquement entre le troisième motif de niveau avant (310) et le troisième motif de niveau arrière (320), dans lequel une longueur du second segment de ligne (312) est le double de la longueur du premier segment de ligne (212) ;
la mesure d'un paramètre S du premier motif de niveau avant (110) et du premier motif de niveau arrière (120) reliés directement, d'un paramètre S du deuxième motif de niveau avant (210), du premier segment de ligne (212) et du deuxième motif de niveau arrière (220) qui sont reliés directement, d'un paramètre S du troisième motif de niveau avant (310), du second segment de ligne (312) et du troisième motif de niveau arrière (320) qui sont reliés directement, et d'un paramètre S d'une structure sous test dans laquelle un dispositif à l'essai (DUT) (102) est ajouté entre le premier motif de niveau avant (110) et le premier motif de niveau arrière (120) ;
l'exécution d'un calcul de paramètres S dans le domaine fréquentiel et la conversion des paramètres S en matrices de paramètres ABCD, puis l'obtention d'une matrice de paramètres ABCD du premier motif de niveau avant (110) et du premier motif de niveau arrière (120) au moyen d'une opération d'extraction de racine ;
la vérification visant à déterminer si une matrice de paramètres ABCD du second segment de ligne (312) dans le troisième motif de test est égale à un produit de deux matrices de paramètres ABCD du premier segment de ligne (212) dans le deuxième motif de test ; et suite à la détermination du fait que la matrice de paramètres ABCD du second segment de ligne (312) est égale au produit de deux matrices de paramètres ABCD du premier segment de ligne (212), le calcul d'un paramètre ABCD d'un DUT désencastré (102) selon une matrice inverse de la matrice de paramètres ABCD du premier motif de niveau avant (110) et du premier motif de niveau arrière (120) ;
suite à la détermination du fait que la matrice de paramètres ABCD du second segment de ligne (312) n'est pas égale au produit de deux matrices de paramètres ABCD du premier segment de ligne (212), l'indication du fait que la matrice inverse de la matrice de paramètres ABCD du premier motif de niveau avant (110) et du premier motif de niveau arrière (120) est incorrecte, de sorte que la matrice de paramètres ABCD du processus de désencastrement du DUT (102) ne peut pas être calculée correctement.

8. Procédé de test de composant haute fréquence selon la revendication 7, dans lequel le premier motif de test (110, 120), le deuxième motif de test (210, 212, 220) et le troisième motif de test (310, 312, 320) présentent la même impédance caractéristique.

9. Procédé de test de composant haute fréquence selon la revendication 7 ou 8, dans lequel [PAD] est une matrice de paramètres ABCD du premier motif de niveau avant (110) et du premier motif de niveau arrière (120), [Dem1] est une matrice de paramètres ABCD lorsque le premier motif de niveau avant (110) et le premier motif de niveau arrière (120) sont reliés directement, [Dem1]=[PAD][PAD], dans lequel la matrice de paramètres ABCD du premier motif de niveau avant (110) et du premier motif de niveau arrière (120) est exprimée comme suit : $\left[PAD\right] = \sqrt{\left[Dem1\right]}$.

10. Procédé de test de composant haute fréquence selon l'une quelconque des revendications 7 à 9, dans lequel [PAD] est une matrice de paramètres ABCD du deuxième motif de niveau avant (210) et du deuxième motif de niveau arrière (220), [Line1] est une matrice de paramètres ABCD du premier segment de ligne (212), [Dem2] est une matrice de paramètres ABCD lorsque le deuxième motif de niveau avant (210), le premier segment de ligne (212) et le deuxième motif de niveau arrière (220) sont directement reliés, dans lequel [Dem2]=[PAD][Line1][PAD].

11. Procédé de test de composant haute fréquence selon l'une quelconque des revendications 7 à 10, dans lequel [PAD] est une matrice de paramètres ABCD du troisième motif de niveau avant (310) et du troisième motif de niveau arrière (320), [Line2] est une matrice de paramètres ABCD du second segment de ligne (312), et [Dem3] est une matrice de paramètres ABCD lorsque le troisième motif de niveau avant (310), le second segment de ligne (312) et le troisième motif de niveau arrière (320) sont directement reliés, dans lequel [Dem3]=[PAD][Line2][PAD].

12. Procédé de test de composant haute fréquence selon l'une quelconque des revendications 9 à 11, dans lequel il est vérifié que la matrice de paramètres ABCD du second segment de ligne (312) dans le troisième motif de test est égale à un produit de deux matrices de paramètres ABCD du premier segment de ligne (212), et est exprimée par [Line2]=[Line1][Line1].

13. Procédé de test de composant haute fréquence selon l'une quelconque des revendications 9 à 12, dans lequel [Golden] est une matrice de paramètres ABCD du DUT désencastré (102), [DUT] est une matrice de paramètres ABCD lorsque le premier motif de niveau avant (110), le DUT (102) et le premier motif de niveau arrière (120) sont directement reliés, [DUT]=[PAD][Golden][PAD], la matrice de paramètres ABCD du DUT désencastré (102) est calculée selon une matrice inverse de la matrice de paramètres ABCD du premier motif de niveau avant (110) et du premier motif de niveau arrière (120) et est exprimée par [Golden]=[PAD]⁻¹[DUT][PAD]⁻¹.
